Europäisches Patentamt

European Patent Office

Office européen des brevets

(11) Veröffentlichungsnummer : **0 054 669**
**B1**

(12) **EUROPÄISCHE PATENTSCHRIFT**

(45) Veröffentlichungstag der Patentschrift :
30.01.85

(21) Anmeldenummer : 81108643.8

(22) Anmeldetag : 21.10.81

(51) Int. Cl.⁴ : **B 65 G 47/14, H 05 K 13/02**

(54) **Vorrichtung zum Entwirren und Zuführen zum Verarbeitungsplatz von ferromagnetischen Schraubenfedern aus dem Haufwerk.**

(30) Priorität : 17.12.80 DE 3047587

(43) Veröffentlichungstag der Anmeldung :
30.06.82 Patentblatt 82/26

(45) Bekanntmachung des Hinweises auf die Patenterteilung : 30.01.85 Patentblatt 85/05

(84) Benannte Vertragsstaaten :
AT CH FR GB IT LI

(56) Entgegenhaltungen :
DE-A- 2 714 651
FR-A- 2 273 739
US-A- 3 118 564
US-A- 3 537 580
ELECTRONICS AND POWER, Band 18, Oktober 1972,
Seiten 360-362, Institution of Electrical Eng., Hitchin
Herts, G.B., E.R. LAITHWAITE: "Unexplained phenomenon at savoy place"

(73) Patentinhaber : Siemens Aktiengesellschaft
Berlin und München Wittelsbacherplatz 2
D-8000 München 2 (DE)

(72) Erfinder : Friemert, Horst, Dipl.-Ing.
Georg-Krauss-Strasse 4
D-8520 Erlangen (DE)

## Beschreibung

Die Erfindung bezieht sich auf eine Vorrichtung zum Entwirren und Zuführen zum Verarbeitungsplatz von ferromagnetischen Schraubenfedern aus dem Haufwerk mittels eines elektromagnetischen Wanderfeldes.

Bekanntlich werden Schraubenfedern ungeordnet in einem Behälter angeliefert und müssen, bevor sie einer automatischen Verarbeitung zugeführt werden können, aus dem ungeordneten Haufwerk Entwirrt werden. Nach dem Entwirren werden dann die Federn dem Verarbeitungsprozeß zugeführt.

Es sind Geräte bekannt, die mittels Druckluft die Federn verwirbeln und durch einen Zufallsprozeß einzelne aus dem Haufwerk entwirren und über Führungsrillen in Zuführschläuche füllen. Der transport der Federn in den Führungsrillen geschieht zum Teil mit Druckluft oder auch nach dem Rüttelfördererprinzip.

Die Schrift US-A-3 118 564 zeigt die Entwirrung von ferromagnetischen Schraubenfedern, die auch verhakt sein können, mittels eines zu- und abschaltbaren stationären elektromagnetischen Feldes.

Es ist weiterhin bekannt, ferromagnetische Schraubenfedern mit Hilfe eines elektromagnetischen Wanderfeldes zu entwirren und in dafür angepäßte, waagrecht liegende Magazine abzulegen.

Der Erfindung liegt die Aufgabe zugrunde, eine Vorrichtung zu entwickeln, mit der es möglich ist, eine räumlich eindeutige, vom Zufall unabhängige Trennung zwischen verhakten und vereinzelten Schraubenfedern zu erreichen und diese dem Verarbeitungsprozeß zuzuführen.

Diese Aufgabe wird gemäß der Erfindung dadurch gelöst, daß eine rechteckige Kassette aus nichtferromagnetischem Material vorgesehen ist, daß die eine Seitenfläche der Kassette mit senkrecht im vorgegebenen Abstand übereinander angeordneten Auslaßöffnungen versehen ist, daß ferner im Innern der Kassette auf ihrer Rückwand Prallkanten jeweils in Höhe der Auslaßöffnungen vorgesehen sind, daß weiterhin in die Auslaßöffnungen Auslaufschläuche aus nichtferromagnetischem Material eingeführt sind, und daß die Rückwand der Kassette derart an einem senkrecht gestellten Linearmotorstator befestigt ist, daß zwischen Kassettenrückwand und Linearmotorstator ein spitzer Winkel ausgebildet ist, dessen Scheitel in der Seitenfläche mit den Auslaufschläuchen der Kassette liegt.

Der Winkel zwischen Kassettenrückwand und Linearmotorstator beträgt vorzugsweise zwischen 5 und 10 Winkelgraden.

Es ist zweckmäßig, die Erhebung der Prallkanten von der Kassettenrückwand auf ein Viertel des Schraubenfederdurchmessers zu bemessen. Es hat sich weiterhin als vorteilhaft erwiesen, daß die Auslaufschläuche aus Kunststoff bestehen.

Es kann weiterhin von Vorteil sein, daß in der Kassette ein Wasch- oder Reinigungsbad für die Schraubenfedern vorgesehen ist.

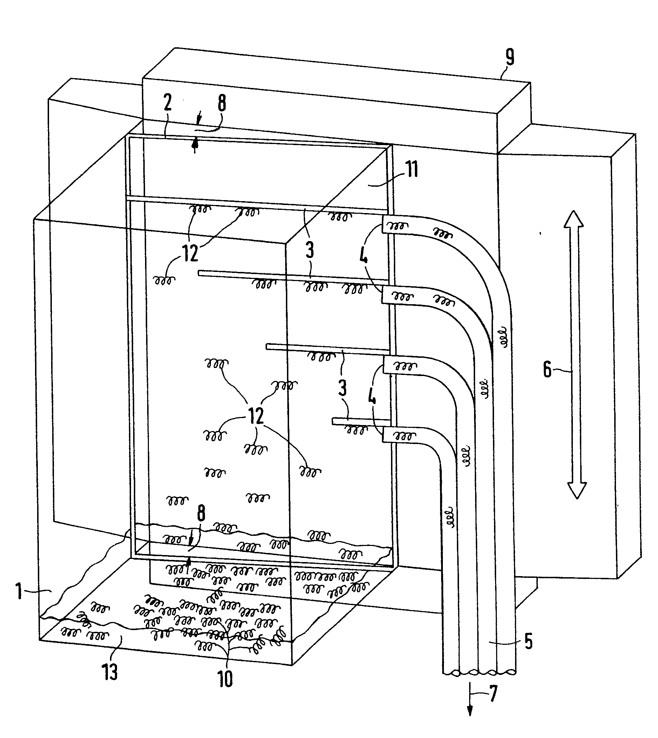

Zur näheren Erläuterung der Erfindung wird auf die Zeichnung und das Ausführungsbeispiel verwiesen.

Die Vorrichtung gemäß der Erfindung nutzt zum Entwirren und Transportieren der ferromagnetischen Schraubenfedern die Kraftwirkungen eines elektromagnetischen Wanderfeldes, wie es von einem Linearmotor erzeugt wird, aus. Im Bereich des elektromagnetischen Wanderfeldes rotieren die Federn um die eigene Längsache, stoßen sich gegenseitig ab und richten sich in eine bestimmte Ordnung. Außerdem werden die ferromagnetischen Schraubenfedern vom elektromagnetischen Wanderfeld angezogen. Diese Einflüsse des magnetischen Wanderfeldes auf die Schraubenfedern bewirken eine zuverlässige Entwirrung aus dem Haufwerk. Wegen dieser Effekte rollen vereinzelte Schraubenfedern bei nach unten gerichtetem Wanderfeld gegen die Schwerkraft am Linearmotorstator entlang nach oben. Dies ist möglich durch die Eigenrotation der Schraubenfedern im elektromagnetischen Wanderfeld einerseits und die durch die Anziehungskraft des Magnetfeldes auf die Schraubenfedern bedingte Reibung andererseits.

Die noch verhakten Schraubenfedern können nicht an dem Linearmotor hochlaufen, da sie an der Eigenrotation behindert sind.

Der Vorteil der erfindungsgemäßen Vorrichtung ist darin zu sehen, daß es möglich ist, eine räumlich eindeutige, vom Zufall unabhängige Trennung zwischen verhakten und vereinzelten Schraubenfedern zu erreichen.

In der Zeichnung ist die Vorrichtung gemäß der Erfindung in der Perspektive schematisch dargestellt. Die zu entwirrenden Schraubenfedern 10 liegen am Boden der Kassette 1 bereit, die aus nichtferromagnetischem Material besteht. Die Kassette 1 ist an einem senkrecht gestellten Linearmotorstator 9 befestigt und zwar derart, daß zwischen der Rückwand 2 der Kassette 1 und dem Linearmotorstator 9 ein spitzer Winkel 8 von z. B. 5° ausgebildet ist. Wird das senkrecht verlaufende Wanderfeld 6 eingeschaltet, beginnen die lose liegenden Schraubenfedern 10, später auch die nach und nach entwirrten Schraubenfedern 12, an der Rückwand 2 der Kassette 1 hochzulaufen, bis sie an eine der Prallkanten 3 anstoßen und dort um die eigene Achse rotierend, in Richtung der Auslaßöffnungen 4 wandern. Diese Wanderung der Schraubenfedern 12 in Richtung der Auslaßöffnungen 4 ist bedingt durch den Neigungswinkel 8 der Rückwand 2 zum Stator 9. Die Auslaßöffnungen 4 sind gerade so groß, daß nur einwandfreie, nicht deformierte Federn durch die Öffnungen in die Auslaufschläuche 5 gelangen können. Die Auslaufschläuche 5 bestehen z. B. aus einem handelsüblichen Kunststoff. Die Längen der Prallkanten 3 sind so bemessen, daß eine gleichmäßige Befüllung der Auslaufschläuche 5 erfolgt.

Die Schläuche 5 sind so gebogen, daß die Federn aus den Auslauföffnungen 4 heraus in den Schläuchen im Bereich des Wanderfeldes 6 nach unten wandern. Solange das Wanderfeld 6 eingeschaltet ist, verbleiben die Federn wegen der Anziehungskraft in dessen Bereich und fallen nach dem Abschalten des Feldes unter dem Einfluß der Schwerkraft in den Schläuchen 5 nach unten und können in Richtung des Pfeiles 7 dem Verarbeitungsprozeß zugeführt werden. Je nach Erfordernis kann in der Kassette 1 ein Wasch- oder Reinigungsbad 13 vorgesehen sein.

**Ansprüche**

1. Vorrichtung zum Entwirren und Zuführen zum Verarbeitungsplatz von ferromagnetischen Schraubenfedern (10, 12) aus dem Haufwerk mittels eines elektromagnetischen Wanderfeldes, dadurch gekennzeichnet, daß eine rechteckige Kassette (1) aus nichtferromagnetischem Material vorgesehen ist, daß die eine Seitenfläche (11) der Kassette (1) mit senkrecht im vorgegebenen Abstand übereinander angeordneten Auslaßöffnungen (4) versehen ist, daß ferner im Innern der Kassette (1) auf ihere Rückwand (2) Prallkanten (3) jeweils in Höhe der Auslaßöffnungen (4) vorgesehen sind, daß weiterhin in die Auslaßöffnungen (4) Auslaufschläuche (5) aus nichtferromagnetischem Material eingeführt sind und daß die Rückwand (2) der Kassette (1) derart an einem senkrecht gestellten Linearmotorstator (9) befestigt ist, daß zwischen Kassettenrückwand (2) und Linearmotorstator (9) ein spitzer Winkel (8) ausgebildet ist, dessen Scheitel in der Seitenfläche (11) der Kassette (1) liegt.

2. Vorrichtung nach Anspruch 1, dadurch gekennzeichnet, daß der Winkel (8) zwischen Kassettenrückwand (2) und Linearmotorstator (9) zwischen 5 und 10 Winkelgraden beträgt.

3. Vorrichtung nach Anspruch 1 oder 2, dadurch gekennzeichnet, daß die Erhebung der Prallkanten (3) von der Kassettenrückwand (2) ein Viertel des Schraubenfederdurchmessers beträgt.

4. Vorrichtung nach einem der vorhergehenden Ansprüche, dadurch gekennzeichnet, daß Auslaufschläuche (5) aus Kunststoff vorgesehen sind.

5. Vorrichtung nach einem der vorhergehenden Ansprüche, dadurch gekennzeichnet, daß in der Kassette (1) ein Wasch- oder Reinigungsbad (13) vorgesehen ist.

**Claims**

1. A device for disentangling ferromagnetic helical springs (10, 12) from a loose mass and feeding them to the working station, by means of a movable electromagnetic field, characterised in that there is provided a rectangular magazine (1) made of a non-ferromagnetic material ; that one lateral face (11) of the magazine is provided with outlet openings (4) which are vertically arranged one above another at a predetermined spacing ; that within the magazine (1), on the rear wall (2) thereof, deflecting edges (3) are arranged at the level of the outlet openings (4) ; that discharge tubes (5) made of a non-ferromagnetic material are inserted into the outlet openings (4) ; and that the rear wall (2) of the magazine (1) is secured to a vertically placed linear motor stator (9) in such a way that an acute angle (8), whose point lies in the lateral surface (11) of the magazine (1), is formed between the rear wall (2) of the magazine and the linear motor stator (9).

2. A device according to Claim 1, characterised in that the angle (8) between the rear wall (2) of the magazine and the linear motor stator (9) is in the range between 5 and 10 degrees.

3. A device according to Claim 1 or 2, characterised in that the elevation of the deflecting edges (3) from the rear wall (2) of the magazine is one-quarter of the diameter of the helical spring.

4. A device according to one of the preceding Claims, characterised in that discharge tubes (5) made of synthetic resin are provided.

5. A device according to one of the preceding Claims, characterised in that a washing or cleaning bath (13) is provided in the magazine (1).

**Revendications**

1. Dispositif pour démêler des ressorts hélicoïdaux (10, 12) ferromagnétiques d'un tas en vrac et pour les envoyer à un emplacement de traitement au moyen d'un champ électromagnétique d'ondes progressives, caractérisé en ce qu'il est prévu un caisson (1) rectangulaire en un matériau non ferromagnétique, en ce que l'une des faces latérales (11) du caisson (1) est munie d'ouvertures de sortie (4) disposées les unes au-dessus des autres à une distance donnée à l'avance, en ce qu'il est prévu, en outre, à l'intérieur du caisson (1) et sur sa paroi arrière (2), des rebords de rebondissement respectivement à hauteur des ouvertures de sortie (4), en ce que, de plus, des tubes souples de sortie (5) en un matériau non ferromagnétique sont introduits dans les ouvertures de sortie (4), et en ce que la paroi arrière (2) du caisson (1) est fixée au stator (9) d'un moteur linéaire placé verticalement de manière à ce que la paroi arrière (2) du caisson et le stator (9) du moteur linéaire fassent entre eux un angle aigu (8) dont le sommet se situe sur la face latérale (11) du caisson (1).

2. Dispositif suivant la revendication 1, caractérisé en ce que l'angle (8) formé entre la paroi arrière (2) du caisson et le stator (9) du moteur linéaire est compris entre 5 et 10 degrés.

3. Dispositif suivant la revendication 1 ou 2, caractérisé en ce que les rebords de rebondissement (3) font saillie de la paroi arrière (2) du caisson sur une distance représentant le quart du diamètre des ressorts hélicoïdaux.

4. Dispositif suivant l'une des revendications précédentes, caractérisé en ce qu'il est prévu des tubes souples de sortie (5) en matière plastique.

5. Dispositif suivant l'une des revendications précédentes, caractérisé en ce qu'il est prévu, dans le caisson (1), un bain de lavage ou de nettoyage (13).